# FASCICULE DE BREVET EUROPEEN

(11) **EP 2 273 349 B1**
(45) Date de publication et mention de la délivrance du brevet: **24.04.2019**
(21) Numéro de dépôt: 10164487.0
(22) Date de dépôt: 31.05.2010
(51) Int. Cl.: G06F 3/02, B29C 45/14, H03K 17/96, G04B 39/00

(54) **Procédé de fabrication d'un verre à touches capacitives pour un instrument électronique, et instrument comprenant un tel verre**
Herstellungsverfahren eines transparenten Elements mit kapazitiven Tasten für ein elektronisches Gerät und dieses Element umfassendes Gerät
Method for manufacturing a transparent element with capacitive keys for an electronic device, and device comprising such a transparent device

(30) Priorité: 10.07.2009 EP 09165225
(43) Date de publication de la demande: 12.01.2011
(73) Titulaire: EM Microelectronic-Marin SA, 2074 Marin (CH)
(72) Inventeur: Longa, Giovanni, 2000, Neuchâtel (CH)
(74) Mandataire: Giraud, Eric

(56) Documents cités:
- EP-A1- 1 544 178
- US-A- 4 257 115
- US-A1- 2007 031 161
- US-A1- 2009 033 635

## Description

L'invention concerne un procédé de fabrication d'un élément transparent ou semi-transparent, tel qu'un verre, muni de touches capacitives pour un instrument électronique. Le verre comprend notamment un film isolant sur lequel sont réalisées des électrodes, des bornes de contact et des pistes conductrices reliant respectivement chaque électrode à une borne correspondante de contact.

L'invention concerne également un instrument électronique, qui comprend un élément transparent ou semi-transparent, tel qu'un verre à touches capacitives obtenu par le procédé de fabrication.

Il faut comprendre comme instrument électronique, tout dispositif portable, tel qu'une montre-bracelet, un téléphone portable, un badge ou un autre appareil, qui est muni d'un écran ou cadran d'affichage d'une information au-dessus duquel est disposé un verre, qui ferme le boîtier de l'instrument.

La réalisation d'un verre muni d'une ou plusieurs électrodes transparentes en tant que touches capacitives pour équiper un instrument électronique est bien connue notamment dans le domaine de l'horlogerie ou des téléphones portables. On peut citer à ce titre le document de brevet EP 0 674 247, qui décrit justement une montre qui comprend un dispositif de commande manuelle. La montre décrite comporte un boîtier métallique formant masse, un verre et un dispositif de commande manuelle comprenant au moins une électrode en tant que touche capacitive, placée sur la face intérieure du verre. Cette touche capacitive peut être considérée comme activée en liaison avec un circuit de traitement dans la montre, au moyen d'un doigt du porteur de la montre, qui est placé en regard de l'électrode sur la face extérieure du verre. Ceci permet de former une capacité totale entre le doigt et l'électrode, ainsi qu'entre l'électrode et la masse constituée par le boîtier métallique de la montre. Le circuit de traitement dans la montre comprend aussi un convertisseur tension-fréquence, dont la fréquence d'oscillation est déterminée par la valeur de la capacité mentionnée ci-dessus. L'électrode transparente est donc reliée de manière bien connue par un conducteur au convertisseur qui est logé dans le boîtier.

Habituellement plusieurs électrodes transparentes, qui constituent des touches capacitives sont disposées sur la face intérieure du verre de l'instrument électronique, tel qu'une montre-bracelet. Le clavier de touches capacitives ainsi formé peut être destiné à remplacer les moyens de commande externes habituels tels que des boutons-poussoirs utilisés pour commander les diverses fonctions d'un instrument électronique. La réalisation de telles électrodes transparentes sur la face intérieure du verre est effectuée par un dépôt d'une couche d'oxyde conducteur, qui peut être conventionnellement un oxyde d'étain et d'indium (ITO), et par une gravure chimique de cette couche d'oxyde conducteur. La couche d'oxyde conducteur est déposée par évaporation sur une épaisseur comprise généralement entre 25 et 75 nm, et de préférence entre 45 et 55 nm. Chaque électrode transparente est reliée par une piste conductrice jusqu'à une zone de contacts en bordure du verre de l'instrument électronique de manière à être reliée par l'intermédiaire d'un connecteur au circuit de traitement dans l'instrument électronique.

Dans d'autres réalisations d'instrument électronique muni d'un verre à touches capacitives, le boîtier de l'instrument, ainsi que le verre ou glace, peuvent être faits en matière plastique. Le verre en matière plastique notamment pour un instrument électronique, tel qu'une montre-bracelet, doit avoir une épaisseur suffisante, d'une part pour résister aux chocs d'agents extérieurs et d'autre part pour supporter une certaine pression hydrostatique lorsque cette montre est immergée. Le verre doit pouvoir supporter une pression qui peut être de l'ordre de 3 bars. Cette forte épaisseur du verre peut ainsi nuire au bon fonctionnement du clavier à touches capacitives disposées sur la face intérieure du verre. En effet, un verre épais conduit à un diélectrique important interposé entre les électrodes des touches capacitives et le doigt de l'utilisateur posé en regard d'au moins une des électrodes à activer, ce qui est généralement un inconvénient de tels verres à touches capacitives.

On peut citer également le document de brevet EP 1 544 178, qui décrit un procédé de fabrication d'électrodes transparentes d'un écran tactile. Un réseau conducteur d'une couche d'oxyde du type ITO est formé sur une face intérieure d'un substrat transparent formant par exemple un verre de montre. Ce réseau conducteur comprend les électrodes transparentes et les pistes conductrices qui relient respectivement les électrodes à une zone de contacts en bordure du substrat. Cette couche structurée d'oxyde conducteur est recouverte encore de deux couches de diélectriques à indice de réfraction différent pour rendre invisibles les électrodes. Cependant comme précédemment décrit, le substrat transparent doit généralement être d'une forte épaisseur. Cela nuit au bon fonctionnement des touches capacitives réalisées sur la face intérieure du substrat, en liaison à un circuit de traitement d'un instrument électronique, ce qui est un inconvénient.

Dans le cas d'une montre à affichage de l'heure numériquement, des touches capacitives peuvent être réalisées dans le dispositif d'affichage à cristaux liquides. Cependant comme le boîtier d'une telle montre est fermé par un verre supplémentaire au dispositif d'affichage à cristaux liquides, une distance relativement élevée subsiste entre le doigt d'un utilisateur posé sur la face extérieure du verre et une électrode d'une touche capacitive à activer. Ceci constitue également un inconvénient.

La demande de brevet US 2007/0031161 A1 décrit un procédé de fabrication d'un panneau profilé de commande à touches capacitives. Pour la réalisation d'un tel panneau, il est utilisé le moulage par injection et des films imprimés. Le panneau profilé comprend un couvercle profilé moulé avec une matière plastique transparente par une méthode de moulage par injection plastique. Le panneau comprend encore un film flexible moulé in situ avec le couvercle et qui comprend des touches capacitives. Cependant il n'est pas prévu de réaliser un élément transparent ou semi-transparent à touches capacitives avec une bonne amélioration de la sensibilité des touches capacitives, ce qui constitue un inconvénient.

La demande de brevet US 2009/00336335 A1 et le brevet US 4,257,115 décrivent un instrument ou une montre avec un élément transparent à touches capacitives. Aucune intégration des touches capacitives n'est prévue par moulage dans une substance plastique. Ainsi, il n'est pas prévu de réaliser un élément transparent ou semi-transparent à touches capacitives avec une bonne amélioration de la sensibilité des touches capacitives, ce qui constitue un inconvénient.

L'invention a donc pour but de pallier aux inconvénients de l'état de la technique en fournissant un procédé de fabrication d'un verre à touches capacitives pour un instrument électronique portable, qui soit suffisamment résistant tout en garantissant une grande sensibilité d'actions des touches capacitives activées notamment par un doigt d'un utilisateur.

A cet effet, l'invention concerne un procédé de fabrication d'un élément transparent ou semi-transparent, tel qu'un verre à touches capacitives pour un instrument électronique portable cité ci-devant, qui comprend les caractéristiques définies dans la revendication indépendante 1.

Des étapes particulières du procédé de fabrication sont définies dans les revendications dépendantes 2 à 11.

Un avantage du procédé de fabrication de un élément transparent ou semi transparent à touches capacitives selon l'invention réside dans le fait que les électrodes des touches capacitives sont moulées dans le matériau constituant l'élément transparent ou semi transparent de l'instrument électronique. Même si cet élément transparent ou semi transparent est réalisé relativement épais pour résister aux chocs d'agents extérieurs et pour supporter une certaine pression hydrostatique, une bonne sensibilité des touches capacitives est garantie. Pour ce faire, les électrodes réalisées sur un film isolant transparent peuvent être situées par exemple à mi-hauteur de l'épaisseur du verre après l'opération de moulage. Ceci améliore la sensibilité de ces touches capacitives intégrées dans le verre par rapport aux verres à touches capacitives de l'état de la technique, car la sensibilité est inversement proportionnelle à la distance entre les électrodes et la surface de contact du verre.

A cet effet, l'invention concerne également un instrument électronique, tel qu'une montre-bracelet, qui comprend un verre à touches capacitives obtenu par le procédé de fabrication.

Les buts, avantages et caractéristiques du procédé de fabrication d'un verre à touches capacitives pour un instrument électronique portable, et de l'instrument le comprenant apparaîtront mieux dans la description suivante sur la base de formes d'exécution non limitatives illustrées par les dessins sur lesquels :
les figures 1a et 1b représentent une vue de dessus et en coupe selon I-I de la figure 1a d'une première forme d'exécution du verre à touches capacitives obtenu par le procédé de fabrication selon l'invention,
la figure 2 représente une vue en coupe selon I-I de la figure 1a d'une seconde forme d'exécution du verre à touches capacitives obtenu par le procédé de fabrication selon l'invention,
la figure 3 représente une vue en coupe selon I-I de la figure 1a d'une troisième forme d'exécution du verre à touches capacitives obtenu par le procédé de fabrication selon l'invention,
la figure 4 représente une vue en coupe selon I-I de la figure 1a d'une quatrième forme d'exécution du verre à touches capacitives obtenu par le procédé de fabrication selon l'invention,
la figure 5 représente une vue en coupe selon I-I de la figure 1a d'une cinquième forme d'exécution du verre à touches capacitives obtenu par le procédé de fabrication selon l'invention, et
la figure 6 représente une vue partielle en coupe d'une montre comprenant un verre à touches capacitives de la seconde forme d'exécution selon l'invention.

Dans la description suivante, tous les éléments qui constituent le verre à touches capacitives pour un instrument électronique portable qui sont bien connus de l'homme du métier dans ce domaine technique ne seront relatés que de manière simplifiée. Il est fait référence principalement à un verre à touches capacitives destiné à équiper une montre-bracelet en tant qu'instrument électronique portable. Toutefois un tel verre à touches capacitives peut être fabriqué pour être utilisé également dans différents autres instruments électroniques.

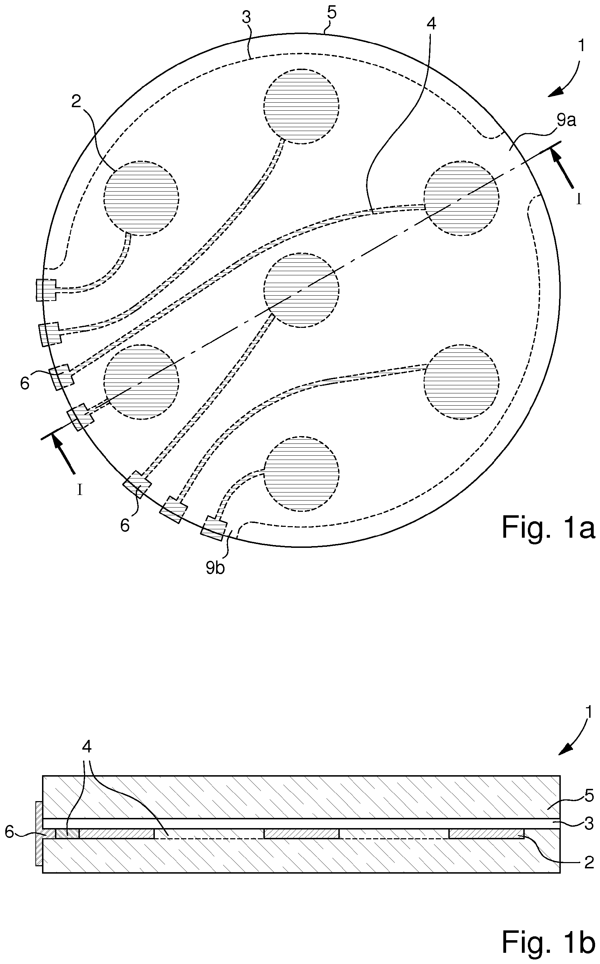

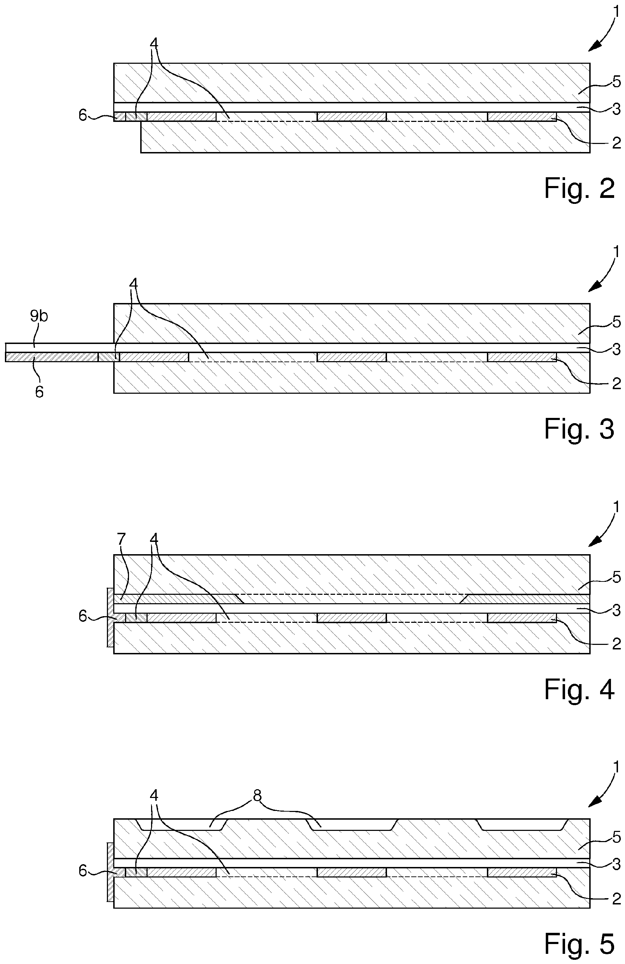

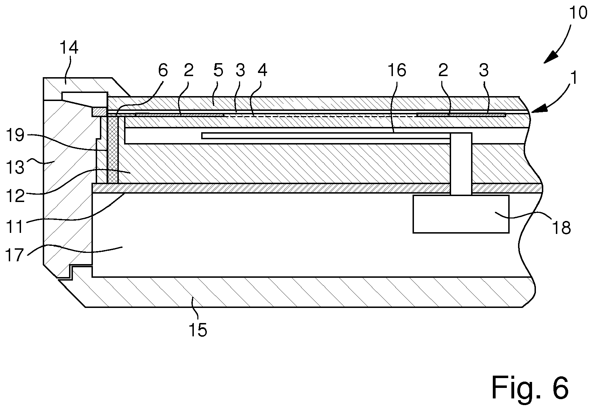

Aux figures 1a et 1b, il est représenté une vue de dessus et en coupe diamétrale d'une première forme d'exécution d'un verre à touches capacitives obtenu par le procédé de fabrication selon l'invention. Le verre 1 peut être de forme circulaire comme représenté à la figure 1a, mais également de forme rectangulaire ou d'une autre forme. Il peut être de forme générale plane comme montré à la figure 1b, mais également de forme bombée non représentée. Ce verre à touches capacitives peut être fabriqué notamment pour équiper une montre du type montre-bracelet discuté ci-après en référence à la figure 6. Sur ces figures 1a et 1b, ainsi que sur les figures 2 à 6, les différents contrastes et épaisseurs des éléments représentés ont été quelque peu exagérés de manière à fournir une meilleure compréhension de l'invention.

Le verre 1 comprend tout d'abord un film isolant 3 sur lequel sont réalisées des électrodes transparentes 2, des pistes conductrices transparentes 4 et des bornes de contact externe 6 d'une zone de contacts. Chaque électrode transparente 2 est reliée par l'intermédiaire d'une piste conductrice 4 respective à une borne de contact 6 de la zone de contacts également transparents. La zone de contacts 6 se trouve de préférence en bordure du verre 1. Les électrodes 2, les pistes conductrices 4, ainsi que les bornes de contact 6 sont obtenues de manière bien connue suite à une gravure chimique d'une couche conductrice d'oxyde d'étain et d'indium (ITO) préalablement déposée sur le film isolant. L'épaisseur de cette couche ITO peut être entre 25 et 75 nm et de préférence entre 45 et 55 nm. L'épaisseur du film isolant peut être équivalente à celle de la couche ITO.

Comme montré à la figure 1a, les électrodes transparentes 2 agissant comme touches capacitives, sont en nombre de sept suffisamment espacées les unes des autres de manière à permettre l'activation d'une seule touche capacitive par un doigt posé sur la surface extérieure de contact du verre. Bien entendu, il pourrait être envisagé d'en réaliser un plus grand nombre ou un nombre plus restreint dans le verre 1 selon l'instrument électronique, qui comprend un tel verre pour accomplir des fonctions spécifiques souhaitées. Lesdites électrodes transparentes 2 peuvent également être de diverses autres formes que celle représentée à la figure 1a, et disposées en périphérie du verre ou sur toute la surface intérieure du verre 1.

Une fois que le film à électrodes transparentes 2, à pistes conductrices 4 et à zone de contacts 6 est réalisé, ce film est disposé dans un moule non représenté pour une opération de moulage du verre de montre. La forme intérieure de ce moule correspond de manière générale la forme du verre à obtenir. Le film 3 peut comprendre des portions 9a et 9b, qui sont initialement d'une longueur déterminée plus grande que celles représentées à la figure 1a, de manière à permettre de maintenir le film à électrodes 2 dans le moule. Les deux portions 9a et 9b sont par exemple pincées en fermant les deux parties constituant ledit moule.

Après fermeture du moule et maintien du film 3 à électrodes transparentes 2 à l'intérieur du moule, une substance plastique chauffée sous forme liquide est introduite par au moins une ouverture du moule afin de le remplir et d'enrober une partie du film à électrodes. Une opération de solidification de la substance plastique est ensuite effectuée et le verre ainsi obtenu est sorti du moule. Une opération d'ébavurage est encore entreprise pour terminer la forme finale du verre. Finalement, les deux portions 9a et 9b sont découpées à fleur du bord du verre 1 ainsi obtenu en laissant la possibilité de venir connecter les bornes de contact externe 6 directement sur la surface latérale du verre 1.

Il peut être encore réalisé des portions conductrices complémentaires de connexion au niveau de la zone de contacts 6 sur une partie de la surface latérale du verre. Ceci permet de faciliter la connexion des électrodes transparentes 2 par l'intermédiaire d'un connecteur électrique, à un circuit de traitement dans l'instrument électronique. Les bornes de contact externe 6 de la zone de contacts peuvent aussi être réalisées dans un autre matériau que l'oxyde ITO, par exemple en métal. Cela permet de réaliser des portions conductrices complémentaires également dans un matériau métallique, qui facilite la connexion par l'intermédiaire du connecteur électrique.

Lors de l'opération de moulage, il peut aussi être imaginé d'injecter dans le moule une substance plastique, voire d'une autre matière transparente, sous la forme de poudre, et ensuite de chauffer ledit moule pour rendre liquide ladite substance enrobant le film 3 à électrodes. Il peut aussi être imaginé de placer tout d'abord le film isolant muni des électrodes transparentes 2 dans un bain de substance plastique liquide et de venir enfermer par la suite le film dans le moule trempé dans la substance plastique liquide. Finalement, cette substance liquide enrobant le film est solidifiée dans le moule et le verre terminé est sorti du moule.

Pour une telle réalisation du verre de montre à touches capacitives intégrées, il peut être utilisé une technique définie sous la dénomination anglaise In-Mould Decoration (IMD), ou encore une technique définie sous la dénomination anglaise Film Insert Moudling (FIM) ou d'autres techniques. Dans la technique FIM, le film 3 à électrodes transparentes 2 peut être intégré dans la substance liquide avant solidification.

A la figure 2, il est représenté une coupe diamétrale d'une seconde forme d'exécution du verre 1 à touches capacitives obtenu par le procédé de fabrication selon l'invention, pour un instrument électronique. Il est à noter que tous les mêmes éléments du verre 1 décrits à la figure 2 portent des signes de référence identiques à ceux représentés aux figures 1a et 1b. De ce fait par simplification, il ne sera pas répété la description de chacun de ces mêmes éléments.

L'unique différence de cette seconde forme d'exécution du verre à touches capacitives réside dans le fait qu'après l'opération de moulage à la sortie du moule, la substance plastique solidifiée constituant le verre ne recouvre pas au moins une face de dessous des bornes de contact externe 6 et une partie des pistes conductrices 4. Ceci permet de pouvoir connecter directement ces bornes de contact externe 6 sur un connecteur électrique.

Il aurait également pu être imaginé de réaliser une opération de moulage du film comme pour la première forme d'exécution, et ensuite effectuer une opération de fraisage depuis le bord du verre du côté de la zone de contacts 6. Cette opération de fraisage d'une partie inférieure du matériau 5 constituant le verre de montre, permet de dégager depuis dessous les bornes de contact externe 6 de la zone de contacts et une portion des pistes conductrices 4. Grâce à cette opération de fraisage, il est possible de venir connecter directement la zone de contacts sur un connecteur électrique relié au circuit de traitement de l'instrument électronique comme montré à la figure 6 expliquée ci-après.

A la figure 3, il est représenté une coupe diamétrale d'une troisième forme d'exécution du verre 1 à touches capacitives obtenu par le procédé de fabrication selon l'invention, pour un instrument électronique. Il est à noter que tous les mêmes éléments du verre 1 décrits à la figure 3 portent des signes de référence identiques à ceux représentés aux figures 1a, 1b et 2. De ce fait par simplification, il ne sera pas répété la description de chacun de ces mêmes éléments.

Les bornes de contact externe 6 se trouvent sur une des deux portions 9a et 9b du film, qui sont pincées dans le moule pour l'opération de moulage. Il peut donc être envisagé de maintenir toute la zone de contacts 6 et une partie des pistes conductrices 4 du côté de la portion 9b pincées par les deux parties du moule en position de fermeture. Cela permet d'obtenir un verre en sortie du moule, qui comprend une partie du film isolant flexible avec les bornes de contact 6 découvertes débouchant de la surface latérale du verre 1. Cette partie du film non représentée peut servir directement comme pour une connexion par câble.

Les bornes de contact 6 peuvent être réalisées par une technique de sérigraphie d'une pâte ayant des particules métalliques sur le film isolant 3. Il peut s'agir d'une pâte d'argent, de graphite ou d'un autre matériau.

A la figure 4, il est représenté une coupe diamétrale d'une quatrième forme d'exécution du verre 1 à touches capacitives obtenu par le procédé de fabrication selon l'invention, pour un instrument électronique. Il est à noter que tous les mêmes éléments du verre 1 décrits à la figure 4 portent des signes de référence identiques à ceux représentés aux figures 1a, 1b, 2 et 3. De ce fait par simplification, il ne sera pas répété la description de chacun de ces mêmes éléments.

Il est prévu dans cette quatrième forme d'exécution du verre à touches capacitives de réaliser une couche décorative 7 au-dessus du film et en partie au-dessus des électrodes transparentes 2. Lorsque le verre 1 équipe un instrument électronique, cette couche décorative 7, qui peut être opaque ou semi-transparente, permet notamment de cacher la vision de la zone de contacts 6 pour un utilisateur de l'instrument.

La couche décorative 7 peut être réalisée sur le film isolant 3 avant ou après la structuration par gravure chimique de la couche conductrice d'oxyde ITO. Une fois que la couche conductrice structurée et la couche décorative sur le film sont réalisées, il peut être entrepris l'opération de moulage du verre 1 dans un moule prévu à cet effet comme indiqué ci-dessus en référence à la figure 1b. La substance plastique liquide enrobe la film 3 et une solidification de cette substance dans le moule est opérée afin que le verre ainsi obtenu ait le film à électrodes et la couche décorative intégré dans la substance plastique transparente solide du verre 1.

Comme en référence à la première forme d'exécution du verre de la figure 1b, il peut être prévu de réaliser des portions conductrices complémentaires de connexion au niveau de la zone de contacts 6 sur une partie de la surface latérale ébavurée du verre. Ces portions conductrices facilitent la connexion des électrodes transparentes 2 par l'intermédiaire d'un connecteur électrique, à un circuit de traitement dans l'instrument électronique. Cependant, il peut être envisagé également que la surface intérieure du moule est configurée de telle manière qu'au moins les bornes de contact 6 ne sont pas recouvertes par la substance plastique solidifiée en sortie du moule comme pour la seconde forme d'exécution. Il peut aussi être envisagé d'avoir une partie du film flexible 3 débouchant de la surface latérale du verre avec les bornes de contact 6 directement accessibles sur la portion 9b du film comme pour la troisième forme d'exécution.

Il est à noter qu'une ou plusieurs couches décoratives 7 peuvent être déposées sur le film isolant 3. La ou les couches décoratives peuvent porter des indications chiffrées ou des symboles ou au moins une image. De plus, une telle couche décorative 7 peut être appliquée également à la seconde forme d'exécution du verre 1 à touches capacitives représentée à la figure 2. Ceci permet de bien cacher la zone de contacts et sa liaison à un connecteur du type Zébra de l'instrument électronique, qui comprend un tel verre.

La figure 5 représente une coupe diamétrale d'une cinquième forme d'exécution du verre 1 à touches capacitives obtenu par le procédé de fabrication selon l'invention, pour un instrument électronique, tel qu'une montre-bracelet. Il est à noter que tous les mêmes éléments du verre 1 décrits à la figure 5 portent des signes de référence identiques à ceux représentés aux figures 1a, 1b, 2, 3 et 4. De ce fait par simplification, il ne sera pas répété la description de chacun de ces mêmes éléments.

Cette cinquième forme d'exécution du verre est très similaire à la première forme d'exécution du verre de la figure 1b. La seule différence est le fait qu'il est réalisé des amincissements 8 de l'épaisseur du verre depuis une surface de contact pour un doigt d'un utilisateur, uniquement au-dessus des électrodes transparentes 2. Ces amincissements 8, qui peuvent être en nombre équivalent au nombre d'électrodes prévues, permettent de réduire localement la distance entre chaque électrode transparente et le doigt en contact du verre dans chaque amincissement 8. Ceci permet d'améliorer la sensibilité d'action des touches capacitives par cette réduction d'épaisseur locale tout en conservant une bonne résistance générale du verre à diverses contraintes externes. Grâce à ces amincissements 8 en épaisseur du verre, il peut être envisagé de réduire la surface de chaque électrode tout en ayant une sensibilité équivalente à celle des autres formes d'exécution décrites ci-devant.

Les amincissements 8 de l'épaisseur de verre peuvent être réalisés pendant l'opération de moulage du verre ou après l'opération de moulage du verre de préférence au terme de toutes les étapes du procédé de fabrication décrites ci-devant. Comme il peut être prévu de réaliser sept électrodes transparentes, il doit être réalisé par moulage ou fraisage sept amincissements 8 de l'épaisseur du verre de diamètre légèrement supérieur au diamètre de chaque électrode ou de dimension légèrement supérieure si chaque électrode est de forme autre que circulaire.

A la figure 6, il est représenté une coupe partielle d'une montre 10 qui comprend un verre 1 à touches capacitives notamment selon la seconde forme d'exécution.

La montre-bracelet 10 représentée comporte de façon connue un boîtier qui est formé d'une carrure 13 fermée à sa partie inférieure par un fond 15 et à sa partie supérieure par un verre 1 délimitant un compartiment 17. Le compartiment 17 permet de loger un mouvement horloger 18 schématiquement représenté, permettant l'affichage d'informations horaires sur un cadran 12 au moyen d'aiguilles 16. Il peut être prévu également une lunette 14 sur la carrure 13, qui recouvre une partie du verre afin de cacher la zone de contacts 6 du verre à touches capacitives 1.

On voit également que le verre 1 de la montre comporte des électrodes transparentes 2 intégrées dans le matériau plastique 5 du verre. Lesdites électrodes 2 sont chacune reliée par des pistes conductrices 4 à des bornes de contact externe 6 d'une zone de contacts située près du bord du verre. Comme indiqué précédemment, les électrodes, les pistes conductrices et les bornes de contact sont réalisées de façon connue sur un film isolant 3 par structuration d'un oxyde conducteur transparent, tel que l'oxyde d'étain et d'indium (ITO) avant l'opération de moulage. Les électrodes 2 et les pistes conductrices 4 peuvent être rendues pratiquement invisibles en déposant des couches diélectriques de compensation non représentées dans les espaces compris entre lesdites électrodes 2 et les pistes 4, comme décrit par exemple dans le document de brevet EP 1 457 865.

Les bornes de contact 6 du verre, qui relient via les pistes conductrices, les électrodes transparentes 2, sont connectées directement sur un connecteur du type Zébra 19, qui traverse le cadran 12. Ce connecteur Zebra 19 est fixé sur une plaque à circuit imprimé 11 placée au dos du cadran. Le connecteur 19 est relié à un circuit intégré non représenté qui comprend notamment le circuit de traitement des actions des touches capacitives, ce qui est bien connu.

Il est à noter que la montre-bracelet 10 peut être équipée d'une autre forme d'exécution du verre 1 à touches capacitives obtenu par le procédé de fabrication. Il peut être envisagé d'intégrer également au moins une couche décorative dans le matériau plastique du verre comme représenté à la figure 4 tout en conservant le verre avec des bornes de contact 6 découvertes comme représentées aux figures 2 et 3. De plus, il peut également être prévu en plus de la couche décorative d'amincir localement le verre du côté de la surface de contact et directement au-dessus des électrodes transparentes comme indiqué en référence à la figure 5.

A partir de la description qui vient d'être faite, plusieurs variantes du procédé de fabrication du verre à touches capacitives, et du verre ainsi obtenu peuvent être conçues par l'homme du métier sans sortir du cadre de l'invention définie par les revendications. Il peut être prévu de placer les électrodes transparentes à mi-hauteur de l'épaisseur du verre sur une face de dessus du film isolant en regard de la surface de contact du verre pour un doigt d'un utilisateur. Il aurait pu être envisagé de réaliser les électrodes transparentes dans des ouvertures pratiquées dans le film isolant support pour limiter l'épaisseur de cet ensemble avant l'opération de moulage du film dans un matériau plastique. Il peut être également envisagé d'enrober dans un matériau plastique intégralement le film isolant avec les électrodes, les pistes conductrices et les bornes de contact, et ensuite de fraiser une partie du verre au niveau des bornes de contact externe pour les découvrir. La substance plastique utilisée pour former le verre à touches capacitives intégrées peut être aussi semi-transparente et colorée. Le film isolant peut être prévu pour comprendre plusieurs ensembles d'électrodes, pistes conductrices et bornes de contact de manière à réaliser plusieurs verres en même temps dans un moule à plusieurs compartiments.

## Revendications

1. Procédé de fabrication d'un élément transparent ou semi-transparent (1) muni de touches capacitives pour un instrument électronique portable (10), comprenant des étapes consistant à :
- placer un film isolant (3), sur lequel sont réalisées des électrodes transparentes (2) en tant que touches capacitives, des pistes conductrices transparentes (4) reliées chacune à une électrode respective et des bornes de contact externe (6) reliées chacune par l'intermédiaire des pistes conductrices aux électrodes transparentes correspondantes, dans une substance plastique transparente (5) ou semi-transparente sous forme liquide à l'intérieur d'un moule, et
- solidifier dans le moule, la substance plastique liquide, qui enrobe au moins une partie du film qui comprend les électrodes, les pistes conductrices et au moins une partie des bornes de contact externe dudit film pour obtenir l'élément transparent ou semi transparent à touches capacitives intégrées dans ladite substance plastique solidifiée de l'élément transparent ou semi transparent avec les électrodes réalisées sur le film isolant transparent situées à mi-hauteur de l'épaisseur de l'élément transparent ou semi transparent après l'opération de moulage pour améliorer la sensibilité des touches capacitives intégrées, qui est inversement proportionnelle à la distance entre les électrodes et la surface de contact de l'élément transparent ou semi transparent.

2. Procédé de fabrication d'un élément transparent ou semi-transparent (1) muni de touches capacitives pour un instrument électronique portable (10), comprenant des étapes consistant à :
- placer un film isolant (3), sur lequel sont réalisées des électrodes transparentes (2) en tant que touches capacitives, des pistes conductrices transparentes (4) reliées chacune à une électrode respective et des bornes de contact externe (6) reliées chacune par l'intermédiaire des pistes conductrices aux électrodes transparentes correspondantes, à l'intérieur d'un moule,
- introduire une substance plastique chauffée sous forme liquide (5) par au moins une ouverture dans le moule, dont la surface intérieure correspond à la forme générale de l'élément transparent ou semi transparent à obtenir, pour placer au moins une partie du film dans la substance plastique liquide, et
- solidifier dans le moule la substance plastique liquide, qui enrobe au moins une partie du film qui comprend les électrodes, les pistes conductrices et au moins une partie des bornes de contact externe dudit film pour obtenir l'élément transparent ou semi transparent à touches capacitives intégrées dans ladite substance plastique solidifiée de l'élément transparent ou semi transparent avec les électrodes réalisées sur le film isolant transparent situées à mi-hauteur de l'épaisseur de l'élément transparent ou semi transparent après l'opération de moulage pour améliorer la sensibilité des touches capacitives intégrées, qui est inversement proportionnelle à la distance entre les électrodes et la surface de contact de l'élément transparent ou semi transparent.

3. Procédé de fabrication d'un élément transparent ou semi-transparent (1) muni de touches capacitives pour un instrument électronique portable (10), comprenant des étapes consistant à :
- placer un film isolant (3), sur lequel sont réalisées des électrodes transparentes (2) en tant que touches capacitives, des pistes conductrices transparentes (4) reliées chacune à une électrode respective et des bornes de contact externe (6) reliées chacune par l'intermédiaire des pistes conductrices aux électrodes transparentes correspondantes, à l'intérieur d'un moule,
- introduire une substance plastique (5) sous forme de poudre par au moins une ouverture dans le moule, dont la surface intérieure correspond à la forme générale de l'élément transparent ou semi transparent à obtenir,
- chauffer le moule pour liquéfier ladite substance plastique, qui occupe tout le volume intérieur du moule, pour placer au moins une partie du film dans la substance plastique liquide, et
- solidifier dans le moule, la substance plastique liquide dans le moule, la substance plastique liquide, qui enrobe au moins une partie du film qui comprend les électrodes, les pistes conductrices et au moins une partie des bornes de contact externe dudit film pour obtenir l'élément transparent ou semi transparent à touches capacitives intégrées dans ladite substance plastique solidifiée de l'élément transparent ou semi transparent avec les électrodes réalisées sur le film isolant transparent situées à mi-hauteur de l'épaisseur de l'élément transparent ou semi transparent après l'opération de moulage pour améliorer la sensibilité des touches capacitives intégrées, qui est inversement proportionnelle à la distance entre les électrodes et la surface de contact de l'élément transparent ou semi transparent.

4. Procédé de fabrication d'un élément transparent ou semi transparent (1) selon l'une des revendications précédentes, **caractérisé en ce qu'**en plaçant le film isolant transparent (3) avec les électrodes transparentes (2), les pistes conductrices transparentes (4) et les bornes de contact externe (6) dans le moule, qui comprend deux parties, au moins deux portions (9a, 9b) du film isolant sont pincées par les deux parties du moule en position de fermeture pour maintenir le film dans une position déterminée à l'intérieur du moule avant d'introduire la substance plastique liquide ou en poudre par au moins une ouverture du moule.

5. Procédé de fabrication d'un élément transparent ou semi transparent (1) selon la revendication 4, **caractérisé en ce que** les portions (9a, 9b) du film (3) non recouvertes par la substance plastique solidifiée dans le moule, sont découpées en dehors du moule en donnant accès aux bornes de contact externe (6) sur la surface latérale de l'élément transparent ou semi transparent.

6. Procédé de fabrication d'un élément transparent ou semi transparent (1) selon la revendication 5, **caractérisé en ce qu'**en sortie du moule et après découpage des portions du film non recouvertes, il est réalisé des portions conductrices complémentaires aux bornes de contact externe (6), ces portions complémentaires s'étendant en partie sur la surface latérale de l'élément transparent ou semi transparent.

7. Procédé de fabrication d'un élément transparent ou semi transparent (1) selon la revendication 4, **caractérisé en ce qu'**une des portions du film flexible, qui sont pincées par les deux parties du moule en position de fermeture, porte toutes les bornes de contact externe (6) et une partie des pistes conductrices, et **en ce que** la substance plastique liquide est solidifiée dans le moule sans recouvrir la portion du film flexible portant lesdites bornes de contact afin d'obtenir un élément transparent ou semi transparent avec une partie du film isolant flexible (3) avec les bornes de contact (6) découvertes débouchant de la surface latérale de l'élément transparent ou semi transparent.

8. Procédé de fabrication d'un élément transparent ou semi transparent (1) selon la revendication 1, **caractérisé en ce que** le film est placé dans le moule de manière qu'au moins une face inférieure des bornes de contact externe (6) en bordure de l'élément transparent ou semi transparent et une partie des pistes conductrices (4) n'est pas recouverte par la substance plastique solidifiée de l'élément transparent ou semi transparent en sortie du moule.

9. Procédé de fabrication d'un élément transparent ou semi transparent (1) selon la revendication 1, **caractérisé en ce qu'**initialement, une couche conductrice transparente d'oxyde d'étain et d'indium est déposée sur une face du film isolant (3), et **en ce qu'**une gravure chimique sélective de ladite couche d'oxyde est effectuée pour obtenir les électrodes transparentes (2), les pistes conductrices transparentes (4) et les bornes de contact externe (6) avant de placer le film dans la substance liquide dans le moule.

10. Procédé de fabrication d'un élément transparent ou semi transparent (1) selon la revendication 9, **caractérisé en ce qu'**au moins une couche décorative (7) est réalisée sur une face du film en partie au-dessus des électrodes (2), des pistes conductrices (4) et des bornes de contact (6) par rapport à une surface supérieure de contact de l'élément transparent ou semi transparent par un doigt d'un utilisateur, **en ce que** le film est ensuite placé dans la substance liquide dans le moule, et **en ce que** la substance liquide est solidifiée dans le moule pour obtenir l'élément transparent ou semi transparent à touches capacitives et à couche décorative intégrées dans la substance liquide solidifiée, la couche décorative disposée entre la face du film portant les électrodes, les pistes conductrices et les bornes de contact, et la surface de contact de l'élément transparent ou semi transparent, permettant de cacher au moins les bornes de contact externe disposées en bordure de l'élément transparent ou semi transparent.

11. Procédé de fabrication d'un élément transparent ou semi transparent (1) selon l'une des revendications précédentes, **caractérisé en ce que** la surface intérieure du moule est formée de telle manière qu'après l'opération de solidification de la substance plastique sur au moins une partie du film, des amincissements (8) d'épaisseur de l'élément transparent ou semi transparent depuis la surface de contact sont réalisés au-dessus des électrodes transparentes.

12. Instrument électronique portable (10) comprenant un élément transparent ou semi transparent (1) à touches capacitives obtenu par le procédé de fabrication selon l'une des revendications précédentes, et un circuit de traitement, qui est relié par l'intermédiaire d'un connecteur aux bornes de contact externe (6) de l'élément transparent ou semi transparent.

## Patentansprüche

1. Verfahren zum Herstellen eines transparenten oder halbtransparenten Elements (1) mit kapazitiven Tasten für ein tragbares elektronisches Gerät (10), umfassend die Schritte:
- Positionieren einer Isolierfolie (3), auf der transparente Elektroden (2) als kapazitive Tasten, transparente Leiterbahnen (4), die jeweils mit einer entsprechenden Elektrode verbunden sind, und externe Kontaktanschlüsse (6) vorgesehen sind, die jeweils über Leiterbahnen mit entsprechenden transparenten Elektroden verbunden sind, in einer transparenten (5) oder halbtransparenten Kunststoffsubstanz in flüssiger Form in einer Gießform, und
- Verfestigen der flüssigen Kunststoffsubstanz, die mindestens einen Teil der Folie umhüllt, der die Elektroden, die Leiterbahnen und mindestens einen Teil der externen Kontaktanschlüsse der Folie umfasst, in der Gießform, um das transparente oder halbtransparente Element mit kapazitiven Tasten, die in die verfestigte Kunststoffsubstanz des transparenten oder halbtransparenten Elements integriert sind, zu erhalten, wobei sich die in der transparenten Isolierfolie hergestellten Elektroden auf halber Höhe der Dicke des transparenten oder halbtransparenten Elements befinden, wenn der Gießvorgang abgeschlossen ist, um die Empfindlichkeit der integrierten kapazitiven Tasten zu verbessern, die umgekehrt proportional zum Abstand zwischen den Elektroden und der Kontaktfläche des transparenten oder halbtransparenten Elements ist.

2. Verfahren zum Herstellen eines transparenten oder halbtransparenten Elements (1) mit kapazitiven Tasten für ein tragbares elektronisches Gerät (10), umfassend die Schritte, bestehend aus:
- Positionieren einer Isolierfolie (3), in der transparente Elektroden (2) als kapazitive Tasten, transparente Leiterbahnen (4), die jeweils mit einer entsprechenden Elektrode verbunden sind, und externe Kontaktanschlüsse (6) vorgesehen sind, die jeweils über Leiterbahnen mit entsprechenden transparenten Elektroden verbunden sind, in einer Gießform,
- Einleiten einer erwärmten Kunststoffsubstanz in flüssiger Form (5) durch mindestens eine Öffnung in die Gießform, deren Innenfläche der allgemeinen Form des zu erhaltenden transparenten oder halbtransparenten Elements entspricht, um mindestens einen Teil der Folie in der flüssigen Kunststoffsubstanz zu positionieren; und
- Verfestigen der flüssigen Kunststoffsubstanz, die mindestens einen Teil der Folie umhüllt, der die Elektroden, die leitenden Bahnen und mindestens einen Teil der externen Kontaktanschlüsse der Folie umfasst, in der Gießform, um das transparente oder halbtransparente Element mit in die verfestigte Kunststoffsubstanz des transparenten oder halbtransparenten Elements integrierten kapazitiven Tasten zu erhalten, wobei sich die in der transparenten Isolierfolie hergestellten Elektroden auf halber Höhe der Dicke des transparenten oder halbtransparenten Elements befinden, wenn der Gießvorgang abgeschlossen ist, um die Empfindlichkeit der integrierten kapazitiven Tasten zu verbessern, die umgekehrt proportional zum Abstand zwischen den Elektroden und der Kontaktfläche des transparenten oder halbtransparenten Elements ist.

3. Verfahren zum Herstellen eines transparenten oder halbtransparenten Elements (1) mit kapazitiven Tasten für ein tragbares elektronisches Gerät (10), umfassend die Schritte bestehend aus:
- Positionieren einer Isolierfolie (3), in der transparente Elektroden (2) als kapazitive Tasten, transparente Leiterbahnen (4), die jeweils mit einer entsprechenden Elektrode verbunden sind, und externe Kontaktanschlüssen (6) vorgesehen sind, die jeweils über Leiterbahnen mit entsprechenden transparenten Elektroden verbunden sind, in einer Gießform,
- Einbringen einer Kunststoffsubstanz (5) in Form eines Pulvers durch mindestens eine Öffnung in die Gießform, deren Innenfläche der allgemeinen Form des zu erhaltenden transparenten oder halbtransparenten Elements entspricht,
- Erwärmen der Gießform, um die Kunststoffsubstanz zu verflüssigen, die das gesamte Innenvolumen der Gießform einnimmt, um mindestens einen Teil der Folie in der flüssigen Kunststoffsubstanz zu positionieren, und
- Verfestigen der flüssigen Kunststoffsubstanz, die mindestens einen Teil der Folie umhüllt, der die Elektroden, die Leiterbahnen und mindestens einen Teil der äußeren Kontaktanschlüsse der Folie umfasst, in der Gießform, um das transparente oder halbtransparente Element mit kapazitiven Tasten, die in die verfestigte Kunststoffsubstanz des transparenten oder halbtransparenten Elements integriert sind, zu erhalten, wobei sich die Elektroden, die in der transparenten Isolierfolie hergestellt sind, auf halber Höhe der Dicke des transparenten oder halbtransparenten Elements befinden, wenn der Gießvorgang abgeschlossen ist, um die Empfindlichkeit der integrierten kapazitiven Tasten zu verbessern, die umgekehrt proportional zum Abstand zwischen den Elektroden und der Kontaktfläche des transparenten oder halbtransparenten Elements ist.

4. Verfahren zum Herstellen eines transparenten oder halbtransparenten Elements (1) nach einem der vorhergehenden Ansprüche, **dadurch gekennzeichnet, dass** beim Positionieren der transparenten Isolierfolie (3) mit den transparenten Elektroden (2), den transparenten Leiterbahnen (4) und den externen Kontaktanschlüssen (6) in der Gießform, die zwei Teile aufweist, mindestens zwei Abschnitte (9a, 9b) der Isolierfolie durch die beiden Teile der Gießform in der geschlossenen Position festgeklemmt werden, um die Folie an einer bestimmten Position in der Gießform zu halten, bevor die flüssige Kunststoffsubstanz oder das entsprechende Pulver durch mindestens eine Öffnung der Gießform eingebracht wird.

5. Verfahren zum Herstellen eines transparenten oder halbtransparenten Elements (1) nach Anspruch 4, **dadurch gekennzeichnet, dass** die nicht durch die verfestigte Kunststoffsubstanz in der Gießform abgedeckten Abschnitte (9a, 9b) der Folie (3) außerhalb der Gießform abgeschnitten werden, was den Zugriff auf die externen Kontaktanschlüsse (6) auf der Seitenfläche des transparenten oder halbtransparenten Elements ermöglicht.

6. Verfahren zum Herstellen eines transparenten oder halbtransparenten Elements (1) nach Anspruch 5, **dadurch gekennzeichnet, dass** beim Ausgeben aus der Gießform und nach dem Abschneiden von nicht bedeckten Abschnitten der Folie leitende Abschnitte ausgebildet werden, die zu den externen Kontaktanschlüssen (6) komplementär sind, wobei diese komplementären Abschnitte teilweise auf der Seitenfläche des transparenten oder halbtransparenten Elements verlaufen.

7. Verfahren zum Herstellen eines transparenten oder halbtransparenten Elements (1) nach Anspruch 4, **dadurch gekennzeichnet, dass** einer der Abschnitte der biegsamen Folie, die durch die beiden Teile der Gießform in der geschlossenen Position festgeklemmt werden, alle externen Kontaktanschlüsse (6) und einen Teil der Leiterbahnen trägt und dass die flüssige Kunststoffsubstanz in der Gießform verfestigt wird, ohne den Abschnitt der flexiblen Folie, die die Kontaktanschlüsse trägt, abzudecken, um ein transparentes oder halbtransparentes Element mit einem Teil der flexiblen Isolierfolie (3) zu erhalten, wobei die nicht abgedeckten Kontaktanschlüsse (6) von der Seitenfläche des transparenten oder halbtransparenten Elements vorstehen.

8. Verfahren zum Herstellen eines transparenten oder halbtransparenten Elements (1) nach Anspruch 1, **dadurch gekennzeichnet, dass** die Folie in der Gießform derart positioniert ist, dass beim Ausgeben aus der Gießform mindestens eine untere Fläche der externen Kontaktanschlüsse (6) am Rand des transparenten oder halbtransparenten Elements und ein Teil der Leiterbahnen (4) nicht mit der verfestigten Kunststoffsubstanz des transparenten oder halbtransparenten Elements bedeckt sind.

9. Verfahren zum Herstellen eines transparenten oder halbtransparenten Elements (1) nach Anspruch 1, **dadurch gekennzeichnet, dass** am Anfang eine transparente leitende Schicht aus Zinn- und Indiumoxid auf einer Fläche der Isolierfolie (3) abgeschieden wird und dass eine selektive chemische Ätzung der Oxidschicht erfolgt, um die transparenten Elektroden (2), die transparenten Leiterbahnen (4) und die externen Kontaktanschlüsse (6) zu erhalten, bevor die Folie in der flüssigen Substanz in der Gießform positioniert wird.

10. Verfahren zum Herstellen eines transparenten oder halbtransparenten Elements (1) nach Anspruch 9, **dadurch gekennzeichnet, dass** mindestens eine Dekorschicht (7) auf einer Fläche der Folie teilweise oberhalb der Elektroden (2), der Leiterbahnen (4) und der Kontaktanschlüssen (6) in Bezug auf eine obere Fläche des transparenten oder halbtransparenten Elements für den Kontakt mit einem Finger eines Benutzers hergestellt wird, dass die Folie anschließend in der flüssigen Substanz in der Gießform positioniert wird und dass die flüssige Substanz in der Gießform verfestigt wird, um das transparente oder halbtransparente Element mit kapazitiven Tasten und mit der Dekorschicht, die in die verfestigte flüssige Substanz integriert sind, zu erhalten, wobei die Dekorschicht zwischen der Fläche der Folie, die die Elektroden, die Leiterbahnen und die Kontaktanschlüsse trägt, und der Kontaktfläche des transparenten oder halbtransparenten Elements angeordnet ist, was ermöglicht, mindestens die externen Kontaktanschlüsse, die am Rand des transparenten oder halbtransparenten Elements angeordnet sind, zu verbergen.

11. Verfahren zum Herstellen eines transparenten oder halbtransparenten Elements (1) nach einem der vorhergehenden Ansprüche, **dadurch gekennzeichnet, dass** die Innenfläche der Gießform derart geformt ist, dass nach dem Vorgang des Verfestigens der Kunststoffsubstanz auf mindestens einem Teil der Folie ausgehend von der Kontaktfläche oberhalb der transparenten Elektroden Verschlankungen (8) der Dicke des transparenten oder halbtransparenten Elements vorgenommen werden.

12. Tragbares elektronisches Gerät (10), umfassend ein transparentes oder halbtransparentes Element (1) mit kapazitiven Tasten, das durch das Herstellungsverfahren nach einem der vorhergehenden Ansprüche erhalten wird, und eine Verarbeitungsschaltung, die über einen Verbinder mit den externen Kontaktanschlüssen (6) des transparenten oder halbtransparenten Elements verbunden ist.

## Claims

1. Method of fabricating a transparent or semi-transparent element (1) with capacitive touch keys for a portable electronic instrument (10), including steps consisting in:
- placing an insulating film (3), on which are formed transparent electrodes (2) forming capacitive touch keys, transparent conductive paths (4), each connected to a respective electrode, and external contact terminals (6), each connected via the conductive paths to the corresponding transparent electrodes, in a transparent or semi-transparent plastic substance (5) in liquid form inside a mould, and
- solidifying, inside the mould, the liquid plastic substance, which coats at least part of the film that includes the electrodes, the conductive paths and at least part of the external contact terminals of said film, so as to obtain the transparent or semi-transparent element with capacitive touch keys integrated within said solidified plastic substance of the transparent or semi-transparent element with the electrodes made on the transparent insulating film located at mid-height in the thickness of the transparent or semi-transparent element after the moulding operation to improve the sensitivity of the integrated capacitive touch keys, which is inversely proportional to the distance between the electrodes and the contact surface of the transparent or semi-transparent element.

2. Method of fabricating a transparent or semi-transparent element (1) with capacitive touch keys for a portable electronic instrument (10), including steps consisting in:
- placing an insulating film (3), on which are formed transparent electrodes (2) forming capacitive touch keys, transparent conductive paths (4), each connected to a respective electrode, and external contact terminals (6), each connected via the conductive paths to the corresponding transparent electrodes, inside a mould,
- introducing a plastic substance (5) heated in liquid form, through at least one aperture in the mould, whose inner surface matches the general shape of the transparent or semi-transparent element to be obtained, so as to place at least one part of the film in said liquid plastic substance, and
- solidifying, inside the mould, the liquid plastic substance, which coats at least part of the film that includes the electrodes, the conductive paths and at least part of the external contact terminals of said film, so as to obtain the transparent or semi-transparent element with capacitive touch keys integrated within said solidified plastic substance of the transparent or semi-transparent element with the electrodes made on the transparent insulating film located at mid-height in the thickness of the transparent or semi-transparent element after the moulding operation to improve the sensitivity of the integrated capacitive touch keys, which is inversely proportional to the distance between the electrodes and the contact surface of the transparent or semi-transparent element.

3. Method of fabricating a transparent or semi-transparent element (1) with capacitive touch keys for a portable electronic instrument (10), including steps consisting in:
- placing an insulating film (3), on which are formed transparent electrodes (2) forming capacitive touch keys, transparent conductive paths (4), each connected to a respective electrode, and external contact terminals (6), each connected via the conductive paths to the corresponding transparent electrodes, inside a mould,
- introducing a plastic substance (5) in powder form, through at least one aperture in the mould, whose inner surface matches the general shape of the transparent or semi-transparent element to be obtained,
- heating the mould to make liquid the plastic substance, which occupies the entire inner volume of the mould, so as to place at least one part of the film in said liquid plastic substance, and
- solidifying, inside the mould, the liquid plastic substance, which coats at least part of the film that includes the electrodes, the conductive paths and at least part of the external contact terminals of said film, so as to obtain the transparent or semi-transparent element with capacitive touch keys integrated within said solidified plastic substance of the transparent or semi-transparent element with the electrodes made on the transparent insulating film located at mid-height in the thickness of the transparent or semi-transparent element after the moulding operation to improve the sensitivity of the integrated capacitive touch keys, which is inversely proportional to the distance between the electrodes and the contact surface of the transparent or semi-transparent element

4. Method of fabricating a transparent or semi-transparent element (1) according to any of the preceding claims, **characterized in that** by placing the transparent insulating film (3) with the transparent electrodes (2), the transparent conductive paths (4) and the external contact terminals (6) in the mould, which has two parts, at least two portions (9a, 9b) of the insulating film are clamped by the two parts of the mould in the closed position to hold the film in a determined position inside the mould prior to introducing a liquid or powder plastic substance through at least one aperture in the mould.

5. Method of fabricating a transparent or semi-transparent element (1) according to claim 4, **characterized in that** the portions (9a, 9b) of the film (3) that are not coated by the solidified plastic substance in the mould are cut out outside the mould giving access to the external contact terminals (6) on the lateral surface of the transparent or semi-transparent element.

6. Method of fabricating a transparent or semi-transparent element (1) according to claim 5, **characterized in that**, upon removal from the mould, and after the non-coated portions of film have been cut out, conductive portions are made that are complementary to the external contact terminals (6), said complementary portions extending in part over the lateral surface of the transparent or semi-transparent element.

7. Method of fabricating a transparent or semi-transparent element (1) according to claim 4, **characterized in that** one of the portions of the flexible film, which are clamped by the two parts of the mould in the closed position, carries all of the external contact terminals (6) and part of the conductive paths, and **in that** the liquid plastic substance is solidified inside the mould without coating the portion of flexible film that carries said contact terminals, so as to obtain a transparent or semi-transparent element with one part of the flexible insulating film (3) with the non-coated contact terminals (6) opening out from the lateral surface of the transparent or semi-transparent element.

8. Method of fabricating a transparent or semi-transparent element (1) according to claim 1, **characterized in that** the film is placed inside the mould such that at least one bottom face of the external contact terminals (6) at the edge of the transparent or semi-transparent element and part of the conductive paths (4) are not coated by the solidified plastic substance of the transparent or semi-transparent element.

9. Method of fabricating a transparent or semi-transparent element (1) according to claim 1, **characterized in that**, initially, a transparent conductive layer of indium and tin oxide is deposited on one surface of the insulating film (3), and **in that** a selective chemical etch is performed on said oxide layer to obtain the transparent electrodes (2), the transparent conductive paths (4) and the external contact terminals (6), before the film is placed in the liquid substance in the mould.

10. Method of fabricating a transparent or semi-transparent element (1) according to claim 9, **characterized in that** at least one decorative layer (7) is made on one face of the film, partly above the electrodes (2), conductive paths (4) and contact terminals (6), relative to a top surface of the transparent or semi-transparent element that comes into contact with a user's finger, **in that** the film is then placed in the liquid substance inside the mould, and **in that** the liquid substance is solidified inside the mould to obtain the transparent or semi-transparent element with capacitive touch keys and a decorative layer integrated within the solidified liquid substance, the decorative layer arranged between the surface of the film carrying the electrodes, the conductive paths and the contact terminals, and the contact surface of the transparent or semi-transparent element, so that at least the external contact terminals arranged at the edge of the transparent or semi-transparent element are concealed.

11. Method of fabricating a transparent or semi-transparent element (1) according to any of the preceding claims, **characterized in that** the inner surface of the mould is formed such that, after the operation of solidifying the plastic substance over at least one part of the film, thinned portions (8) are made in the thickness of the transparent or semi-transparent element from the contact surface above the transparent electrodes.

12. Portable electronic instrument (10) including a transparent or semi-transparent element (1) with capacitive touch keys obtained via the fabricating method according to any of the preceding claims, and a processing circuit, which is connected, via a connector, to the external contact terminals (6) of the transparent or semi-transparent element.
